(19) Europäisches Patentamt
European Patent Office
Office européen des brevets

(11) EP 2 339 755 A1

(12) **EUROPEAN PATENT APPLICATION**

(43) Date of publication:
29.06.2011 Bulletin 2011/26

(51) Int Cl.:
$H03M\ 1/08^{(2006.01)}$    $H04L\ 27/34^{(2006.01)}$

(21) Application number: 09252809.0

(22) Date of filing: 16.12.2009

(84) Designated Contracting States:
AT BE BG CH CY CZ DE DK EE ES FI FR GB GR HR HU IE IS IT LI LT LU LV MC MK MT NL NO PL PT RO SE SI SK SM TR
Designated Extension States:
AL BA RS

(71) Applicant: NXP B.V.
5656 AG Eindhoven (NL)

(72) Inventors:
• Rutten, Robert
Redhill, Surrey RH1 1DL (GB)

• Janssen, Erwin
Redhill, Surrey RH1 1DL (GB)
• Breems, Lucien Johannes
Redhill, Surrey RH1 1DL (GB)

(74) Representative: Ashton, Gareth Mark
NXP Semiconductors
Intellectual Property and Licensing Department
Betchworth House
57-65 Station Road
Redhill, Surrey RH1 1DL (GB)

(54) **Clock jitter compensation**

(57)    A method of compensating for sampling clock jitter, the method comprising: receiving a modulated signal; sampling the modulated signal using a clock signal having a clock jitter to provide a sampled modulated signal ($Y_{AM}$); downmixing the sampled modulated signal with a local oscillator signal (LO) to provide a downmixed signal having a first modulating signal ($Y_{downmixed,I}$) and a second modulating signal ($Y_{downmixed,Q}$); calculating a phase difference between the first modulating signal and the second modulating signal; and feeding back the calculated phase difference ($\varphi_r$) to the downmixed signal to correct for the clock jitter.

Fig. 3

**Description**

This invention relates to compensation of clock jitter in data converters, for example, where a sampling clock signal in an analogue to digital converter introduces clock jitter into a received signal.

In many data-converter systems (e.g. analog to digital converters - AD converters), a clock is used to clock data in or out. This clock is typically contaminated with clock jitter, which can limit the dynamic range of such converters, especially in the high frequency/dynamic range and wide bandwidth data-converters. Discussions on the nature and effects of clock jitter can be found in "The effect of clock jitter on the DR of $\Sigma\Delta$ modulators", by R. van Veldhoven, Peter Nuijten, Paul van Zeijl, (Proceedings ISCAS 2006, pp. 2009-2012, May 2006).

Some solutions have been suggested to address this problem of 'cleaning' a signal of clock jitter. Some of these require an additional clean input tone to be provided in a guaranteed clean part of the input spectrum to effectively act as a reference guide tone.

It will be appreciated that clock jitter will have effect on different types of signal. For some modulation types (such as frequency modulated (FM) signals, phase modulated (PM) signals, time modulated (TM) signals, and the like), the modulated information cannot be distinguished from clock jitter. On pure (i.e. unmodulated) signals and amplitude modulated (AM) signals, however, the modulation and clock jitter effect can be measured separately.

To illustrate this, the effect of clock jitter on an amplitude modulated signal is described below with reference to Eq. 1 which mathematically describes an amplitude modulated (AM) signal, $Y_{AM}$.

$$Y_{AM} = \left(1 + A_s \cos\left(\omega_s t\right)\right) \cdot e^{j\omega_c t} \qquad \text{Eq. 1}$$

The carrier frequency equals $\omega_c$, the signal modulation frequency equals $\omega_s$, $t$ represents the time, $A_s$ represents the depth of the modulation, and the strength of the carrier itself is normalized to 1.

When the cos function above is expanded in powers of e and simplified, the equation becomes:

$$Y_{AM} = \tfrac{1}{2} A_s e^{j(\omega_c + \omega_s)t} + \tfrac{1}{2} A_s e^{j(\omega_c - \omega_s)t} + e^{j\omega_c t} \qquad \text{Eq. 2}$$

Eq. 2 therefore shows that an AM signal is composed of three frequency components, one at the carrier frequency, and two around the carrier frequency with a frequency distance of $\omega_s$ (signal modulation frequency).

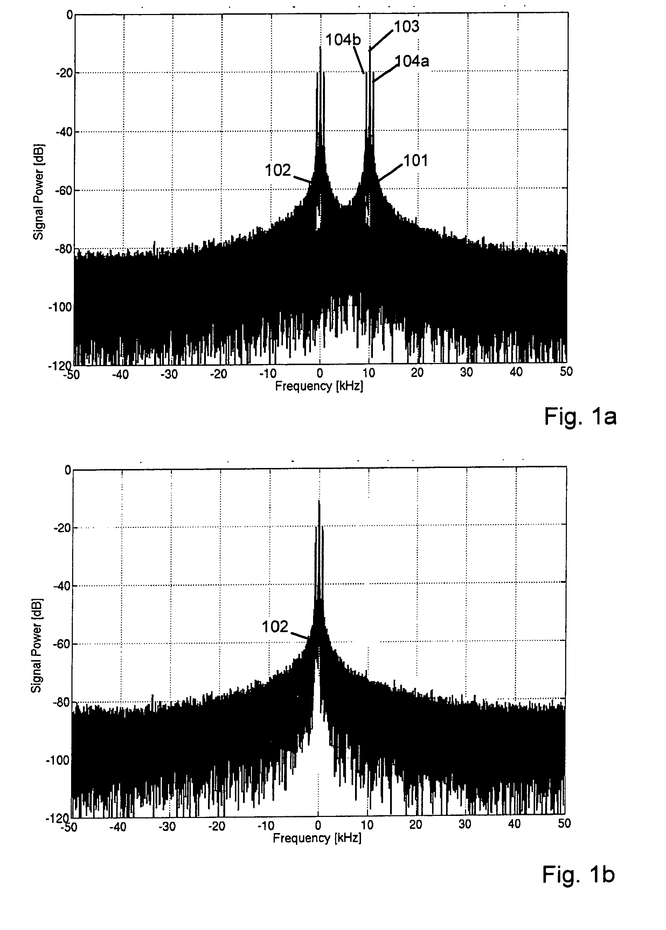

This can be further illustrated with reference to Figures 1a & 1b. Figure 1a illustrates the power spectrum 101 of an amplitude modulated signal at a frequency of 10 kHz (the curve offset from 0Hz) and the power spectrum 102 of this signal after downmixing/demodulation (the curve centred on 0Hz). Figure 1b illustrates for clarity the downmixed signal 102 only. The carrier tone of the sampled AM signal is located at a carrier frequency of 10kHz. The modulation frequency ($\omega_s$) equals 70 Hz, which introduces the two sidetones 104a, 104b around the carrier frequency 103 at distances of 70Hz (as discussed above with reference to Eq. 2).

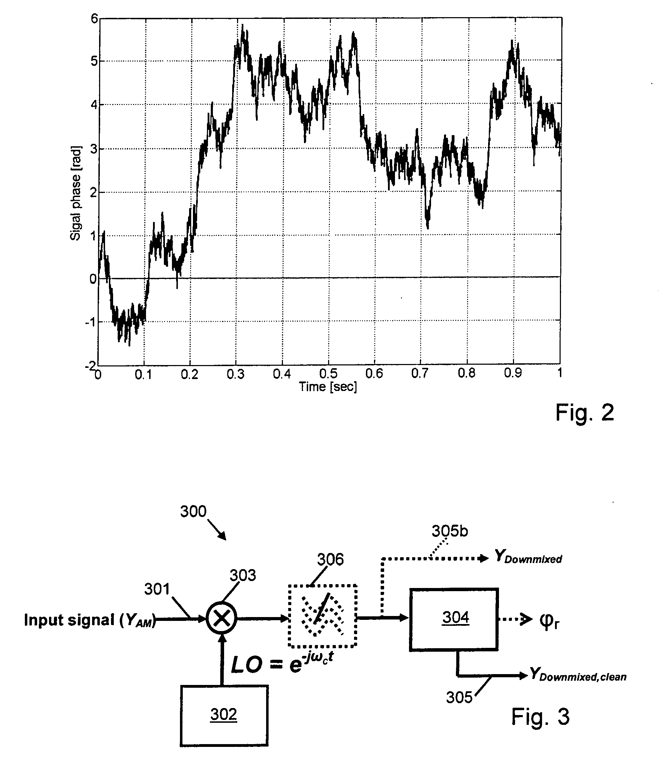

The AM signal 101 shown in figure 1a has been sampled with a clock which suffers from clock jitter. If no clock jitter is present, the tones would be spikes at the three frequencies. Due to the clock jitter on the clock, each tone experiences 'side-lobes' or additional peaks around the central peaks themselves, which can clearly be seen in Figures 1a & 1b as a form of peak broadening. The contamination of the channel due to clock jitter results in poor signal to noise and distortion ratio (SINAD) after demodulation. An exemplary plot of signal phase deviation as a function of time, caused by a time-varying degree of clock jitter, is illustrated in figure 2.

Furthermore, when a received signal contains other channels that are received at the same time, the clock jitter contamination on this channel at 10 kHz can also affect these other channels, even though they may be located at one or more different frequencies. For example, for AM signal broadcasting, a weak channel that is transmitting at 50 kHz higher or lower than that of the 10kHz channel would still also suffer from the effects of clock jitter contamination of the strong neighbour channel.

As discussed above, before an amplitude modulated signal is demodulated, the channel is downmixed with a local oscillator (LO) signal to create a zero-centred intermediate frequency (zero-IF). This downmixing can be done digitally (i.e. in the digital domain) by mixing with $e^{-j\omega ct}$. This downmixing serves to remove/cancel out the amplitude carrier frequency enveiope containing the desired information to thereby aiiow access to that information. This step does not increase the channel quality (it is only a shift in frequency), but it enables easier demodulation. The power spectrum 102 after downmixing is represented by the lone curve in Fig.1b.

The resulting signal $Y_{downmixed}$, when the clock jitter is not taken into account, is given by:

$$Y_{downmixed} = \tfrac{1}{2} A_s e^{j(\omega_s)t} + \tfrac{1}{2} A_s e^{j(-\omega_s)t} + 1 \qquad \text{Eq. 3}$$

This signal consists of a DC tone (i.e. the third component '1') and two frequency components to the left and right of this DC tone at a distance equal to the modulation frequency $\omega_s$. Where there is no clock jitter present the phase of this signal is constant, since the phases of the negative and positive frequency components cancel each other out.

Clock jitter contamination of modulated signals and the resulting contamination of information is generally undesirable, and is a particular problem for many data converters known in the art.

One solution for overcoming this problem is to use a clock signal that is less susceptible to jitter. This, however, may require more highly toleranced components and can result in increased cost for a circuit.

It would therefore be advantageous to be able to account for and correct for clock jitter without the necessity of ensuring a jitter-free clock signal.

It is an object of the invention to address one or more of the above mentioned problems.

In accordance with a first aspect of the invention there is provided a method of compensating for clock jitter, the method comprising:

> receiving a modulated signal;
> sampling the modulated signal using a clock signal having a clock jitter to provide a sampled modulated signal;
> downmixing the sampled modulated signal with a local oscillator signal to provide a downmixed signal having a first modulating signal and a second modulating signal;
> calculating a phase difference between the first modulating signal and the second modulating signal; and
> feeding back the calculated phase difference to the downmixed signal to correct for the clock jitter.

The modulated signal may be any type of modulation signal where the phase of the ideal modulated signal is constant, for example an amplitude modulated signal.

The modulated signal may be downmixed using/in a quadrature system so that the first and second modulating signals are in quadrature with each other, i.e. are nominally 90° out of phase with each other.

The phase difference may be calculated by calculating an arctan function of a ratio between the first and second modulating signals. The phase difference may also be calculated using one or more other mathematical functions that enable the angle between the first and second modulating signals to be calculated (for example, sin, cos, arcsin, arccos, Taylor series approximation, etc).

The phase difference may be calculated by mixing the first and second modulating signals according to a CORDIC algorithm. Other algorithms or functions that allow for calculation and/or cancellation of the phase difference between the first and second modulating signals may also be used.

The calculated phase difference can be fed back to the downmixed signal by combining the calculated phase difference with the local oscillator signal to provide a combined local oscillator signal and downmixing the sampled modulated signal using the combined local oscillator signal. This may be provided in the form of one or more feedback loops or the like.

The calculated phase difference can alternatively be fed back to the downmixed signal by applying the calculated phase difference to a mixer combining the first and second modulating signals to provide a jitter-compensated downmixed signal.

The calculated phase difference may be fed back via a filter. The filter may be an integrator.

The calculated phase difference may be applied to a further modulated signal having a different carrier frequency to the modulated signal to compensate for clock jitter in and/or reciprocal mixing of a sampled modulated signal from the further modulated signal. Once the degree of clock jitter is known for a given first frequency at a given point in time, based on the known relationship and variation between the degree of clock jitter contamination at two or more different frequencies, it is possible to compensate for clock jitter at another frequency based on the clock jitter determined from the first frequency.

The phase difference in the further modulated signal may be calculated based on the phase difference in the modulated signal, and the gain of the phase difference between the modulated and further modulated signals, wherein the gain is calculated by dividing the carrier frequency of the modulated signal by the carrier frequency of the further modulated signal.

This can allow the calculated phase deviation/difference for a first sampled signal to be used to compensate for phase deviation/difference in another sampled signal, located at another frequency. This frequency of the further sampled signal may be located in the same band as the frequency of the first sampled signal.

According to a second aspect of the invention, there is provided a data converter comprising:

a sampler configured to sample a received modulated signal at with a sampling clock signal to provide a sampled modulated signal;

a downmixer configured to downmix the sampled modulated signal with a local oscillator signal to provide a downmixed signal having a first modulating signal and a second modulating signal;

a phase estimator configured to receive the first and second modulating signal, calculate a phase difference between the first and second modulating signals and feed back the calculated phase difference to the downmixed signal to correct for clock jitter in the sampling clock signal.

The invention is described in further detail below by way of example and with reference to the accompanying drawings in which:

figure 1a is a power spectrum of a received and sampled AM signal with clock jitter (curve offset from 0Hz), and the same AM signal downmixed to zero-IF (curve centred on 0Hz) also including clock jitter;

figure 1b shows only the power spectrum of the AM signal downmixed to zero-IF from Figure 1a;

figure 2 is a plot of phase deviation of a sampled signal due to clock jitter;

figure 3 is a schematic block diagram illustrating a first embodiment of the invention;

figure 4 is a schematic block diagram illustrating an exemplary implementation of a phase estimator of figure 3;

figure 5a is a power spectrum of a received and sampled AM signal with clock jitter (curve offset from 0Hz), and the same AM signal downmixed to zero-IF (curve centred on 0Hz) clean of clock jitter.

figure 5b is a power spectrum of only the AM signal downmixed to zero-IF from figure 5a;

figure 6 is a schematic block diagram illustrating an alternative embodiment of the invention;

figure 7 is a schematic block diagram illustrating a further multi-channel embodiment of the invention;

figure 8a is a power spectrum of a received and sampled multichannel AM signal with clock jitter (curve offset from 0Hz), and a single channel of the same AM signal downmixed to zero-IF (curve centred on 0Hz) clean of clock jitter;

figure 8b is the power spectrum of the clock jitter free channel of the downmixed AM signal from figure 8a;

figure 9a is a power spectrum of a received and sampled multichannel AM signal with clock jitter (background curve), and the same AM signal downmixed to zero-IF (foreground curve) clean of clock jitter;

figure 9b illustrates only the power spectrum of the clock jitter free downmixed AM signal from figure 9a;

figure 10a is a power spectrum of a received and sampled multichannel AM signal without clock jitter but contaminated by reciprocal mixing earlier in the receive chain (background curve), and the same AM signal downmixed to zero-IF (foreground curve) clean of reciprocal mixing;

figure 10b illustrates the power spectrum of the reciprocal mixing free downmixed AM signal from figure 10a;

figure 11 illustrates a further multichannel embodiment of the present invention for compensating for clock jitter and reciprocal mixing error;

figure 12a illustrates the power spectrum of a received and sampled multichannel AM signal with clock jitter and reciprocal mixing error (background curve), and the same AM signal downmixed to zero-IF (foreground curve) clean of clock jitter and reciprocal mixing error; and

figure 12b illustrates only the power spectrum of the AM signal downmixed to zero-IF (foreground curve of figure 12a) clean of clock jitter and reciprocal mixing error from figure 12a.

In one embodiment described herein, there is provided a method of compensating for sampling clock jitter in a modulated signal. This method involves downmixing a sampled modulated signal with a digital local oscillator signal to provide a downmixed signal having a first modulating signal and a second modulating signal. The method then involves calculating a phase difference between the first modulating signal and the second modulating signal and feeding back the calculated phase difference to the downmixed signal to correct for the clock jitter.

The calculated phase difference between the first modulating signal and the second modulating signal represents the phase deviation inherent in the downmixed signal from an ideal signal. This phase deviation represents the clock jitter inherent in the received modulated signal. Once this has been calculated it is possible to use this to compensate for the phase deviation due to clock jitter in the sampled signal.

Other advantages will also be discussed. For example, once the phase deviation of one modulated signal in a given band is known, it becomes possible to correct or compensate for clock jitter inherent in other channels at different frequencies based on this same measurement.

Furthermore, reciprocal mixing errors (i.e. phase deviation errors introduced when a local oscillator [LO] signal [a 'dirty' LO signal] is used to downmix a sampled signal but introduces phase deviations in the process) can also contribute undesirable errors into a signal. The techniques and algorithms described herein can also be used to compensate for these errors. This is discussed in more detail below.

In a general aspect, the techniques described herein utilise constant phase signals (such as AM signals or even pure unmodulated signals) to measure deviations instead of using an additional input tone (as discussed in the background). Another improvement is that the measurement is dosed loop, which makes this technique more robust.

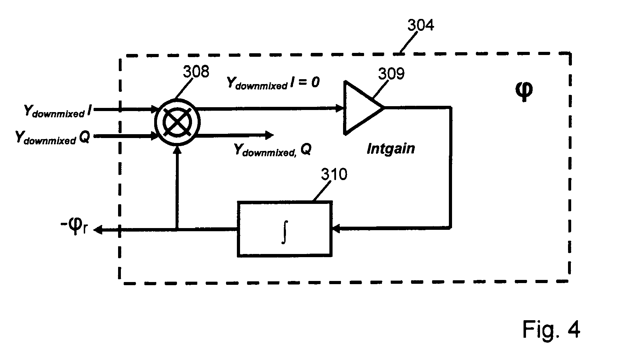

An exemplary embodiment is illustrated in the block diagrams in figures 3 & 4. This particular embodiment is directed towards receiving and compensating for clock jitter in AM signals.

Figure 3 depicts a data converter 300 configured to receive and compensate for clock jitter in an amplitude modulated (AM) signal. The data converter 300 comprises an input 301, a local oscillator 302, a downmixer 303, a phase estimator 304, and a first output 305. In some embodiments, for example where the input signal $Y_{AM}$ contains modulated signals at multiple frequencies, the data converter 300 may optionally include a bandpass filter 306 (as is illustrated by the dotted line inclusion of this component).

The input 301 receives a sampled modulated signal $Y_{AM}$. In this embodiment, the input 301 is a physical electrical connection to a receiver such as an A-D converter (not shown) that has received and sampled a modulated signal from the analog to the digital domain. In some embodiments this receiver/A-D converter is a general purpose computer, and in other embodiments the receiver/A-D converter may be a dedicated A-D converter specifically for receiving and converting certain types of modulated signal. The input 301 may be connected to a number of other devices that are able to receive and sample modulated signals, and may be connected to such devices in a variety of different ways (for example, physical wires, wireless communication, a combination of the two, or the like).

The local oscillator 302 provides a local oscillator signal LO (which can consist of multiple components) to the downmixer 303 (described in detail detail below) to allow for downmixing of the sampled modulated signal $Y_{AM}$. The local oscillator 302 is, in this embodiment, a digital sine and cosine wave generator that can be set to different frequencies. In other embodiments the LO can alternatively be an analog wave generator, and/or can produce other wave types (such as sawtooth, etc) suitable for downmixing alternative modulated signals. The skilled person will appreciate that other alternatives are within the scope of the invention.

The downmixer 303 downmixes the modulated signal $Y_{AM}$ with the local oscillator signal LO to provide a first modulating signal $Y_{downmixed,I}$ and a second modulating signal $Y_{downmixed,Q}$ In this embodiment, the downmixer 303 is a multiplier circuit that convolves the modulated signal $Y_{AM}$ with the signals produced by the local oscillator signal LO.

The downmixer separately performs the following two functions:

- mixes the sine wave output from the local oscillator with the received signal to produce a first modulating signal (which we shall denote as the real 'I' or 'inphase' component); and
- mixes the cosine wave output from the local oscillator with the received signal to produce a second modulating signal (which we shall denote as the imaginary 'Q' or 'quadrature' component) that is 90' phase-shifted with respect to the I component.

Whilst the sine and cosine LO signals have been used to achieve the I and Q components respectively, it will be appreciated that the cosine LO signal could be used to achieve the first modulating signal and the sine LO signal could be used to achieve the second modulating signal. This still provides for the relative 90' phase shift between the I and Q components.

Other functional components may be used to downmix the received and sampled modulated signal to achieve the first and second modulating signals instead of a multiplier circuit. The two types of signals will be explained below.

The phase estimator 304 calculates and determines the phase difference between the first and second modulating signals (I and Q branches of the quadrature signal) from the downmixer 303. The phase deviation indicative of clock jitter in a modulated signal is needed to compensate for said clock jitter.

As discussed above, the first modulating signal will represent the 'I' part of the signal and the second modulating signal will represent the 'Q' part of the signal. The I component may alternatively be described as the 'real' part, with the Q component the 'imaginary' part. The phase estimator 304 is operable to calculate the arctan of the ratio between the second modulating signal and the first modulating signal to thereby calculate the phase deviation inherent in the received modulated signal. The mathematical approach describes calculating the function *arctan(Q/I)*. This operation can be implemented in a variety of ways. For example, a phase estimator may use a Taylor series approximation of the *arctan* function. Another more practical way of calculating the phase between the two components is to use a phase estimator 304 as shown in figure 4.

The phase estimator 304 utilises a complex mixer 308 to calculate the phase deviation in the signal. The mixer 308 can also serve to clean the signal of clock jitter. In this example, the mixer 308 is a CORDIC mixer that operates using a CORDIC algorithm. This arrangement also includes an amplifier 309 and an integrator circuit 310. The complex mixer 308 is electrically connected to the amplifier 309 followed by the integrator circuit 310. The output of the integrator circuit 310 outputs the cleaned jitter-free signal, and is electrically connected back to an input of the mixer 308 to provide a feedback loop.

Given that the input of the phase estimator 304 is a complex signal, if the phase of the complex signal changes over time (i.e. indicated by variation in angle between the I and Q signal branches as defined in the complex plane), this is likely to be caused by clock jitter.

The mixer 308 rotates this phase deviation in the opposite direction, i.e. so that the angle defined by the Real (I) and imaginary (Q) components in the complex plane is rotated through 180°. In this way, it is possible to calculate the phase deviation inherent in the downmixed signal. It is also possible using the control loop illustrated in Figure 4 to jointly cancel out this phase deviation inherent in the signal. At each instant of time the CORDIC mixer 308 calculates the phase deviation at that time instant, and can then apply this phase deviation as a negative phase offset or shift to the received signal (in other words, a phase offset that is equal to the phase deviation due to clock jitter, thus 'dephasing' the signal). Therefore, the mixer 308 can provide a constant phase signal. Note that this mixer 308 does not (in this embodiment) change or affect the frequency of the signal - only the phase is changed. In this embodiment, the phase estimator 304 is able to calculate and compensate for phase deviation in the received signal. Other embodiments may utilise the phase estimator 304 to merely calculate the phase deviation inherent in the signal, the phase deviation being 'cleaned' from the signal in other ways (discussed in more detail below).

The amplifier 309 is included to help keep the feedback loop of this exemplary phase estimator 304 stable. In alternative embodiments the phase estimator 304 may also comprise a filter (not shown) to help obtain better phase measurement in one or more particular frequency bands.

The integrator circuit 310 controls the input it receives to 0. This means that the I signal branch is regulated to 0. If the value of the I branch is zero, the phase of the combined IQ signal in inherently constant. Therefore, the phase estimator 304 when operational will calculate and clean a jittered signal to provide a clean signal at its output 305. The phase estimator may have a further output in other embodiments (as mentioned above) to provide an indication of the phase deviation inherent in the received signal. This is illustrated by the dashed (optional) output designated φ in figure 3. This calculated phase deviation can then be used in different ways to clean the received signal/channel of clock jitter or even other signals/channels within received signals. Such possibilities are discussed in more detail in later embodiments.

In the phase estimator of figure 4, the output if the Q branch, i.e. the "$Y_{downmixed,Q}$" signal output, is also cleaned of clock jitter and can be considered to be a "dephased" signal. In some embodiments, this clean Q signal can be considered to be a by-product that arises as a result of calculating the phase deviation of the received signal from the I and Q components. However, this "residual" component may still be used for other purposes. For example, this clean Q component could be used as a clean signal for further processing of other signals. It will also be appreciated that for other types of phase estimation (such as Taylor expansion and the like), this clean Q signal might not be produced at all in/by the phase estimator 304.

It will be appreciated that there are other ways of identifying the phase deviation inherent in the signal Y other than by the use of a CORDIC mixer and that the example given illustrates just one way in which the phase deviation in a signal can be calculated.

The input 301 and local oscillator 302 are electrically connected to the downmixer 303 so that they are both in electrical communication with the downmixer 303. The downmixer 303 is electrically connected to first output 305. In this embodiment the first output 305 provides the cleaned and compensated signal output from the phase estimator 304. In embodiments where the phase estimator 304 does not compensate for phase deviation in the signal but just calculates the phase deviation, a second output (305b - shown in dashed lines) may be included to provide a direct output for the contaminated downmixed modulated signal. The calculated phase deviation from the phase estimator 304 can then be used to clean this 'jittered' signal. A purpose of this will be explained in later embodiments.

In operation, the data converter 300 receives an amplitude modulated signal $Y_{AM}$ at the input 301. This signal $Y_{AM}$ is the digital output of the sampling A-D (analog-to-digital) converter connected to the input 301, and has been sampled using a clock that has introduced clock jitter into the signal.

The signal $Y_{AM}$ is passed to the downmixer 303 to mix the amplitude modulated signal $Y_{AM}$ with the local oscillator signal LO from the local oscillator 302. The signal $Y_{AM}$ is preferably mixed to zero rad/sec to produce a zero-IF (intermediate frequency) signal. This may be done by mixing the signal $Y_{AM}$ with $e^{-j\omega ct}$ in the digital domain. Specifically, in this embodiment the local oscillator 302 is preferably providing a signal LO at the same frequency as the carrier frequency of the received AM signal $Y_{AW}$. This is to mix the signal down into the '1' and 'Q' modulating signals as discussed above, for onward provision to the phase estimator 304.

In other embodiments the local oscillator 302 can provide a signal that has a different frequency to that of the carrier frequency of the received signal, or multiple signals with different frequencies and/or phases, dependent on the nature of the modulated signal being received.

If there is any other content in the signal (i.e. multiple channels), which can often be the case in a wideband receiver, the other content can be optionally filtered using a low pass or band pass filter 306 after downmixing. When the remaining downmixed signal is clean of this other content, the phase deviation of the signal can be measured using the phase estimator 304.

The phase estimator 304 receives the I and Q signals and uses the mixer arrangement in figure 4 to calculate and compensate for the clock jitter in the signal. The output of the phase estimator 304 is a jitter-free signal that has had the phase deviation cancelled out.

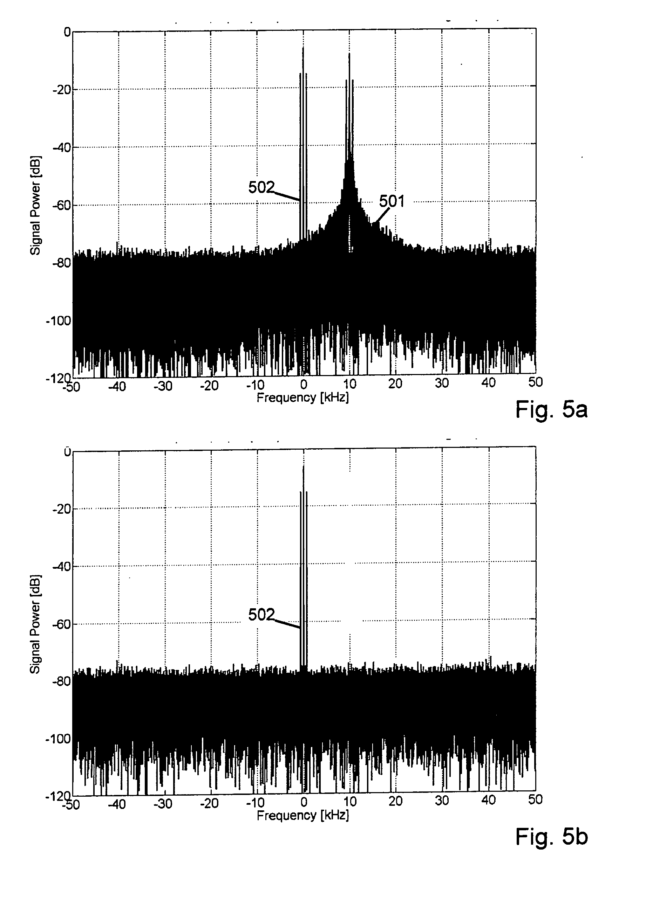

Figures 5a & 5b illustrate how the embodiment of figures 3 and 4 provide for compensation of clock jitter. Figure 5a shows an input signal 501 (offset from 0Hz) and a resulting corrected downmixed signal 502 (centred on 0Hz) Figures 5b shows the corrected downmixed signal 502 in isolation for clarity. These clearly show that the clock jitter on the corrected downmixed signal 502 is highly suppressed, evidenced by the absence of peak broadening in the corrected downmixed signal 502.

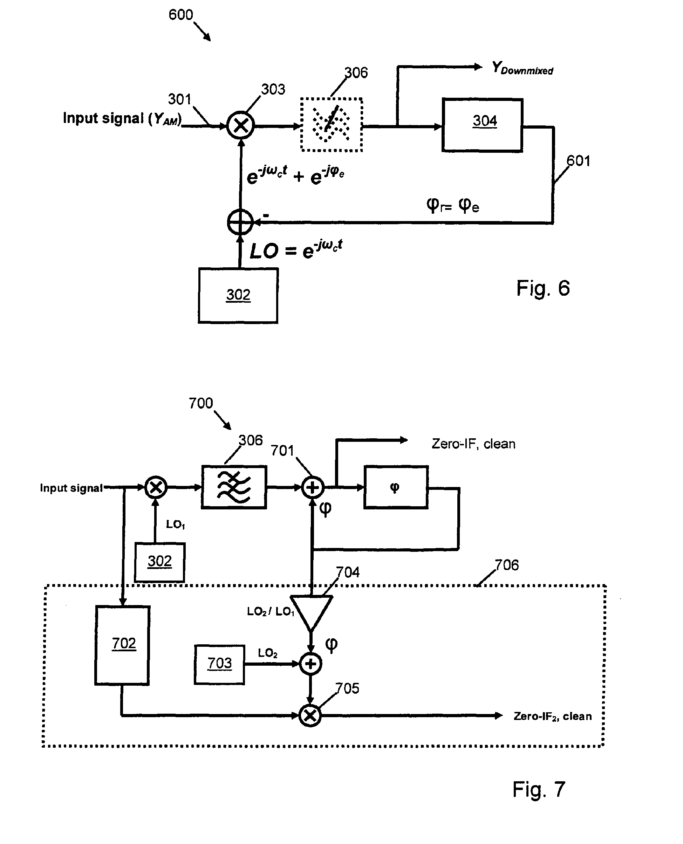

Figure 6 illustrates an alternative configuration of the data converter of figure 3, in which the phase estimator 304 provides a phase error signal $\varphi_r$ to the local oscillator 302 via a feedback path 601. In this embodiment, the phase deviation is applied as a negative phase offset to the local oscillator signal LO produced by the local oscillator 302 so that the phase deviation due to clock jitter is cancelled out or compensated for directly during downmixing of the sampled signal.

It should be noted that whilst these embodiments are directly primarily towards calculating and compensating for clock jitter in amplitude modulated signals, the above described principles and techniques can be applied to other types of modulated (or unmodulated) signals provided that the signal itself does not contain information that has been encoded based on a change in phase or phase modulated, or the like. The skilled person will appreciate that other modifications to allow for similar processing of other such input signals are within the scope of the invention.

In some situations more than one channel may be received and sampled by a single A-D converter. As a result, any clock jitter that would be introduced into one channel would also contaminate other channels. If the complete band is sampled with one clock, i.e. multiple channels are logged in using the same A-D converter, the clock jitter has the same real-time behaviour for all channels in the received band. The amount of clock jitter for a certain channel is linear with frequency, as described in "The effect of clock jitter on the DR of $\Sigma\Delta$ modulators", by R. van Veldhoven, Peter Nuijten, Paul van Zeijl, (Proceedings ISCAS 2006, pp. 2009-2012, May 2006). Therefore, the technique described above with reference to Figures 3-6 can also be applied to clean other channels that have experienced clock jitter contamination from the same source.

In the data converter 600 of Fig. 5, the real-time phase deviation $(-)\varphi_e$ indicating clock jitter in the signal is present at the output of the phase estimator 304. This indication can be re-used to clean up other channels in the band, the other channels being located at different frequencies. The modulation type of these other channels is not restricted to being the same type as the modulation type involved in the first signal.

Provided that the frequencies of the channels being received are known, then it is possible to calculate the clock jitter gain on each channel and compensate for the clock jitter on different channels using the calculated clock jitter on the first channel.

The multi-channel converter 700 illustrated in figure 7 is configured to measure clock jitter in a single channel, and re-use this information to clean up one or more other channels in the band with little additional hardware. The converter 700 shown in Figure 7 is substantially the same as the converter 600 of figure 5 (i.e. where the phase estimator 304 provides an indication of the phase deviation $(-)\varphi_e$), with the addition of some further components and minor modifications.

The converter 700 includes a first branch mixer 701 configured to apply the calculated phase deviation to the downmixed signal to compensate for the clock jitter. The converter 700 also includes a bandpass filter 306 (which is merely optional in the embodiments of figures 3, 4 and 6), a delay module 702, a second local oscillator 703 for the second channel, a divider block 704, and a second branch mixer 705. These components are together configured to provide a second branch of the system for compensating for clock jitter in a second channel of a received signal.

As discussed above, the bandpass filter 306 is configured to filter out all channels but one for the first branch so that clock jitter can be calculated for this channel (i.e. such that it can act as a reference channei).

The delay module 702 is configured to have the same group-delay as that resulting from the filter 306 in the main branch. This is to ensure that the signals in the respective branches are in synchronization with one another during separate processing.

The second local oscillator 703 generates a local oscillator signal $LO_2$ for downmixing the second channel of the received signal by means of the second branch mixer 705. The divider block 704 calculates the clock jitter gain on the second channel based on the detected clock jitter in the first channel. The difference of clock jitter strength between those channels is equal to $F_2/F_1$, i.e. the ratio between the frequency of the second channel and the frequency of the first channel. The divider block 704 is therefore configured to calculate, based on the known channel frequencies and the clock jitter in the first channel, the clock jitter in the second channel and apply this as a phase offset to the second local oscillator signal $LO_2$.

The second branch mixer 705 downmixes the second channel of the signal with the second local oscillator signal $LO_2$. This allows the converter 700 to compensate for the clock jitter in the second channel during downmixing of the signal.

In summary, the signal for providing downmixing of the first channel with frequency $F_1$ for the first branch is $LO_1$, (i.e. the signal from the first local oscillator 302). A signal at a second channel having a second frequency $F_2$ is delayed and mixed with the second local oscillator signal $LO_2$. The difference of gain between the clock jitter inherent in both channels of the signal is determined and equalized by the divider circuit 704. The clock jitter phase is added to the second local oscillator signal $LO_2$ and the resulting signal is used to obtain the downmixed zero-$IF_2$ signal of the second channel, from which clock jitter is removed.

The second branch 706 for the second channel can be implemented as many times as needed for a given number of channels received as an input signal.

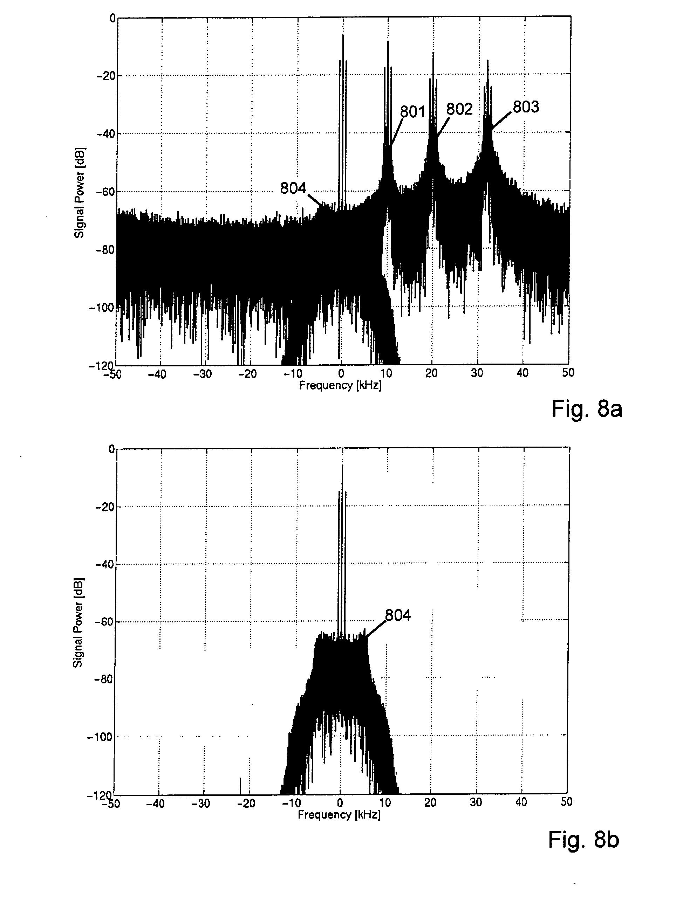

Figures 8a & 8b illustrate examples of a multi-channel input signal, in this case three channels at 10kHz, 20kHz and 32kHz. The spectrum in figure 8a shows each of the channels 801, 802, 803 before downmixing, together with the resulting downmixed and bandwidth-limited signal 804 of the 32kHz input signal 803. Figure 8b shows the downmixed signal 804 alone for clarity.

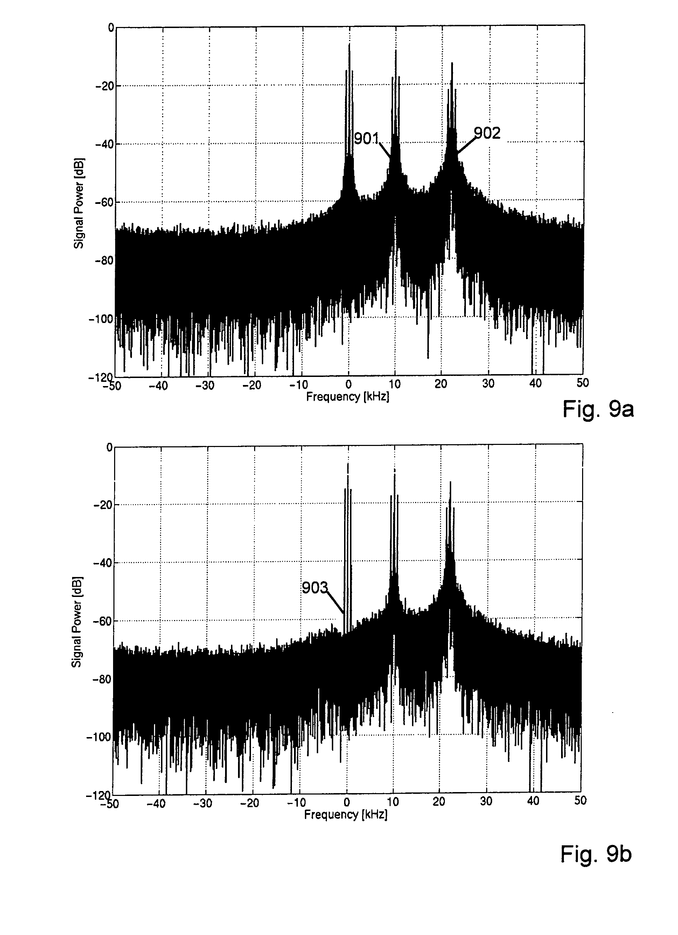

The spectra in figures 9a & 9b show an example of where a channel 901 at 10kHz is mixed to zero-IF by using clock jitter suppression derived from another channel 902 at 32kHz, as described above with reference to the embodiment of figure 7. The clock-jitter suppressed zero-IF signal 903 is shown by itself in figure 9b. By applying the correct gain setting for the clock jitter signal, the clock jitter around the zero-IF signal is largely suppressed.

Clock jitter type errors may also be introduced into a sampled signal due to downmixing of the signal with a 'dirty' local oscillator signal in the RF domain. This is known as a 'reciprocal mixing' error. As the above techniques provide for detection and cancellation of phase deviation errors in a given signal, these same techniques can also used to correct for phase deviation errors that are due to reciprocal mixing errors.

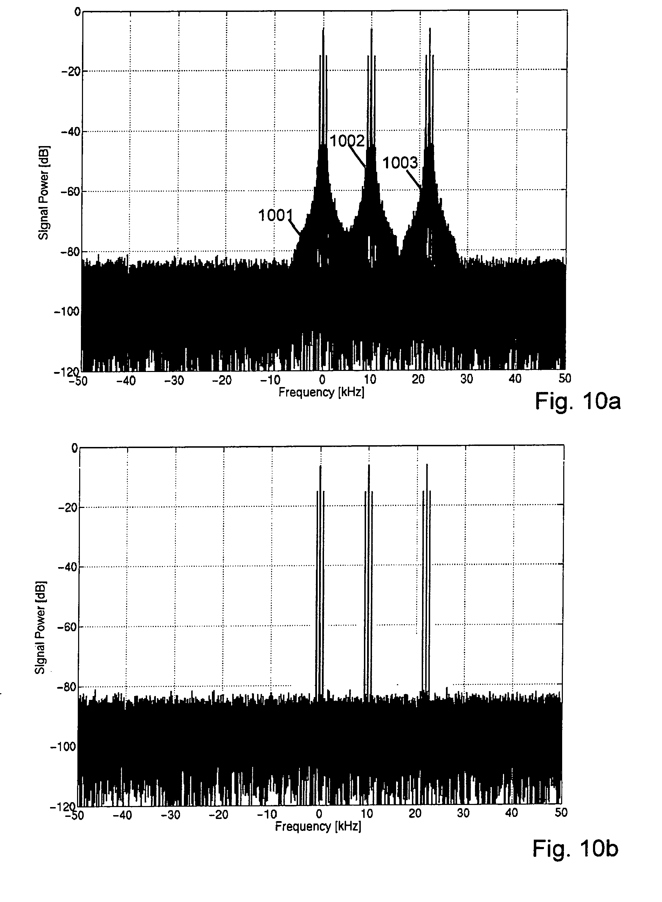

For example, a receiver system often requires an analogue radio frequency (RF) mixer, which mixes a given channel to zero-IF or near zero-IF. An RF mixer is sometimes used to mix a whole band to near zero-IF, while the exact zero-IF mixing is done by other mixers (e.g. 302). Figure 10a illustrates the effect of reciprocal mixing when three AM modulated signals 1001, 1002, 1003 are located in a band that is downmixed by a single RF mixer. The skilled person would appreciate the different possible sources in the signal chain that could give rise to this particular type of error. We have therefore not shown these sources explicitly shown in the figures.

This reciprocal mixing error arises due to mixing the input signal with a 'dirty' RF-mixer which introduces further side-lobes around the channels. A channel is selected by mixing one channel down to zero-IF, resulting in the characteristics depicted in the spectra of figure 10a. The non-centred spectra show that the strength of the 'side-lobes' are substantially identical for each channel-frequency. The compensation technique described above with reference to figure 7 can also be used to clean channels from reciprocal mixing errors, as once the total phase deviation is calculated (i.e. from clock jitter and reciprocal mixing), the signal can be cleaned of this phase deviation.

In the illustrative example of figure 10a, the amount of compensation is identical for all channels, so the gain-factor should be 1, (which makes compensating for such errors somewhat easier). Another advantage is that the complete band with all the channels is compensated, since there is no frequency dependence. This compensated signal is shown in figure 10b.

In many cases, both clock jitter error and reciprocal mixing error may be present in a signal. In these cases, a single measurement to establish the degree of jitter in one channel may not be sufficient to compensate for multiple channels. As there are two error sources in a signal, the system complexity may increase, e.g. by a 'two-point' measurement.

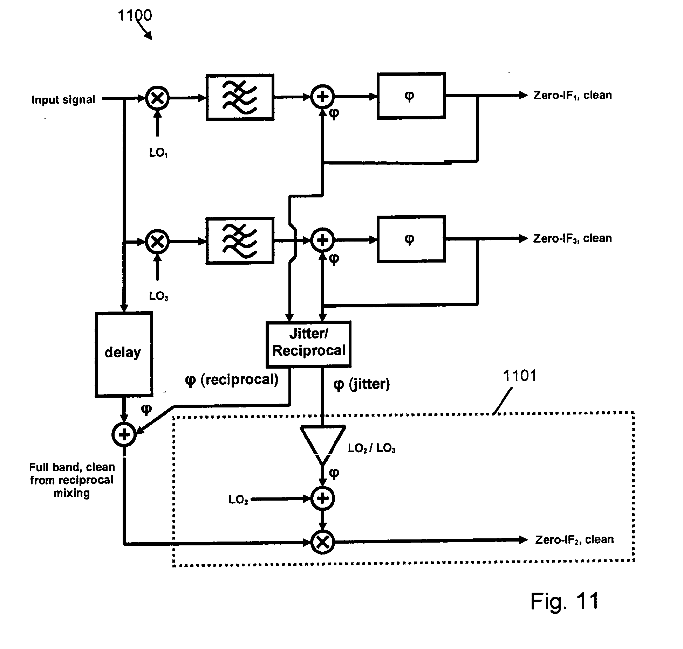

Figure 11 illustrates a further data converter 1100 configured to compensate for both clock jitter error and reciprocal mixing error. The data converter is essentially an extension of the previous embodiments if figures 3, 4, 6 and 7, with an additional branch for processing a third channel, and a further function block for identifying the extent of clock jitter and reciprocal mixing errors on each channel. In this embodiment, an signal is received and sampled and the phase deviation measurements for two different channels are measured, one is measured on channel 1 (mixed with $LO_1$), the next phase deviation is measured with channel 3 (mixed with $LO_3$). After compensating, those two channels experience compensation for both clock jitter and reciprocal mixing. The phase information of these compensation systems can be used to clean other channels both from clock jitter and reciprocal mixing, with minor additional hardware. Since the phase deviation due to reciprocal mixing error information is identical for both measurements (in this case) and the clock jitter phase information has a known amplitude relation (as discussed above), the two phase deviations can be separated in a mathematical way. As both relationships are known, a function block can be implemented to operate on the determined phase deviation measurements from the two measured channels to compensate for both clock jitter and reciprocal mixing errors in other channels. This can provide for a more reliable and accurate way to compensate for both clock jitter errors and reciprocal mixing errors.

To illustrate further, we shall refer to one phase input as φ*(LO₁)* and a second as φ*(LO₃)*. The two independent phase parts can be calculated by the following:

$$\varphi(reciprocal) = \frac{1}{F_{LO1} - F_{LO3}}\left(\varphi(LO_3) - \frac{F_{LO3}}{F_{LO1}} \cdot \varphi(LO_1)\right) \qquad \text{Eq. 4}$$

$$\varphi(jitter) = \varphi(LO_3) - \varphi(reciprocal) \qquad \text{Eq. 5}$$

The $F_{LOx}$ equals the frequency of the LOx signal and can be a variable in the system, depending on which channels should be received. The phase φ*(reciprocal)* is added to a delayed version of the input signal. This delay is equal to the delay introduced by the low-pass filters. After adding this reciprocal phase, the whole band is cleaned from reciprocal mixing errors.

The φ*(jitter)* is determined according to Eq. 5. This signal is multiplied by a gain, since the strength of this parameter depends on the frequency of the channel. After correcting that gain, it is added to the phase of the LO mixer. This compensation technique can be carried out for as many channels as are required, by copying the system in the dashed box 1101 of figure 11 for each desired channel.

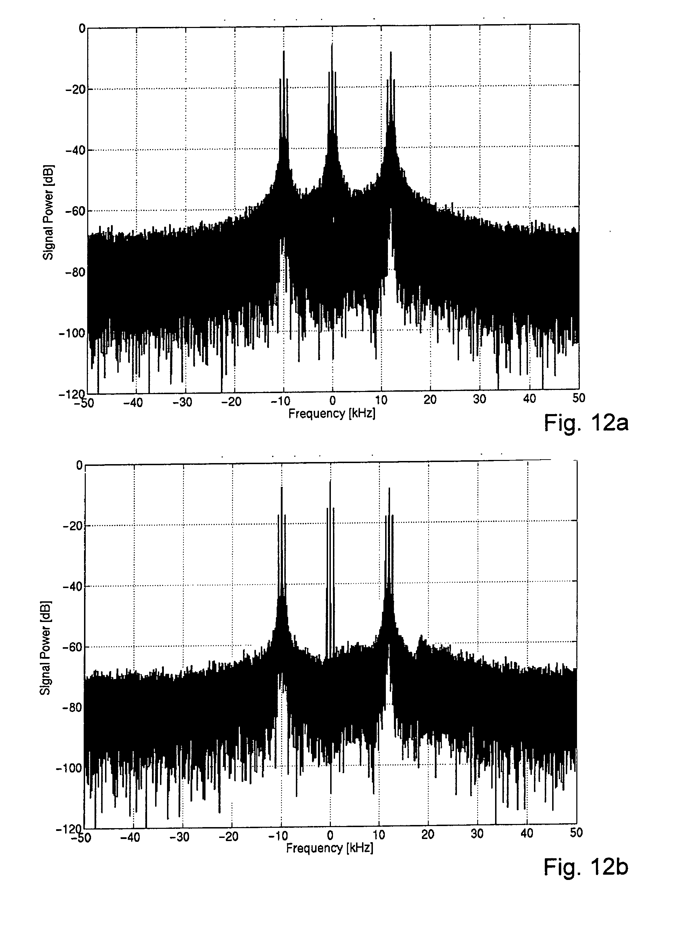

Figures 12a & 12b show the result of this arrangement. The input signal (the background curve - containing three channels in this example) suffers from both reciprocal mixing and clock jitter. The two phases φ*(reciprocal)* and φ *(jitter)* are extracted and used for cleaning the second channel. According to the two equations above, the difference between the two phase errors is frequency dependent, so the accuracy of Eq. 4 and Eq. 5 increases when the two frequencies of the LO signal are not close to each other. The background curve in figure 12a shows the spectrum without compensation, while the curve in figure 12b represents the spectrum with compensation applied.

Other embodiments are intentionally within the scope of the invention as defined by the appended claims.

**Claims**

1. A method of compensating for sampling clock jitter, the method comprising:

    receiving a modulated signal;
    sampling the modulated signal using a clock signal having a clock jitter to provide a sampled modulated signal ($Y_{AM}$);
    downmixing the sampled modulated signal with a local oscillator signal (LO) to provide a downmixed signal having a first modulating signal ($Y_{downmixed,I}$) and a second modulating signal ($Y_{downmixed,Q}$);
    calculating a phase difference between the first modulating signal and the second modulating signal; and
    feeding back the calculated phase difference ($\varphi_r$) to the downmixed signal to correct for the clock jitter.

2. The method of claim 1 wherein the modulated signal is amplitude modulated.

3. The method of claim 1 wherein the first and second modulating signals are in quadrature with each other.

4. The method of any preceding claim wherein the phase difference ($\varphi_r$) is calculated by calculating an arctan function of a ratio between the first and second modulating signals.

5. The method of claim 4 wherein the phase difference is calculated by mixing the first and second modulating signals according to a CORDIC algorithm.

6. The method of any preceding claim wherein the calculated phase difference ($\varphi_r$) is fed back to the downmixed signal by combining the calculated phase difference with the local oscillator signal (LO) to provide a combined local oscillator signal and downmixing the sampled modulated signal ($Y_{AM}$) using the combined local oscillator signal.

7. The method of any of claims 1 to 5 wherein the calculated phase difference ($\varphi_r$) is fed back to the downmixed signal by applying the calculated phase difference to a mixer (308) combining the first and second modulating signals to provide a jitter-compensated downmixed signal.

8. The method of claim 7 wherein the calculated phase difference is fed back via a filter (310).

9. The method of any preceding claim wherein, for a further modulated signal having a different carrier frequency to the modulated signal, the calculated phase difference is used to compensate for clock jitter in and/or reciprocal mixing error in a sampled modulated signal from the further modulated signal.

10. The method of claim 9, wherein the phase difference in the further modulated signal is calculated based on the phase difference in the modulated signal, and the gain of the phase difference between the modulated and further modulated signals, wherein the gain is calculated by dividing the carrier frequency of the modulated signal by the carrier frequency of the further modulated signal.

11. A data converter (300) comprising:

a sampler configured to sample a received modulated signal at with a sampling clock signal to provide a sampled modulated signal ($Y_{AM}$);
a downmixer (303) configured to downmix the sampled modulated signal with a local oscillator signal (LO) to provide a downmixed signal having a first modulating signal and a second modulating signal;
a phase estimator (304) configured to receive the first and second modulating signal, calculate a phase difference between the first and second modulating signals and feed back the calculated phase difference to the downmixed signal to correct for clock jitter in the sampling clock signal.

Fig. 1a

Fig. 1b

Fig. 2

Input signal ($Y_{AM}$)

$LO = e^{-j\omega_c t}$

$Y_{Downmixed}$

$\varphi_r$

$Y_{Downmixed, clean}$

Fig. 3

Fig. 4

Fig. 5a

Fig. 5b

600

Input signal ($Y_{AM}$) — 301 — ⊗ 303 — [306] — $Y_{Downmixed}$

$e^{-j\omega_c t} + e^{-j\varphi_e}$

304

601

$\varphi_r = \varphi_e$

⊕ –

$LO = e^{-j\omega_c t}$

302

**Fig. 6**

700

306 — 701 — Zero-IF, clean

Input signal — ⊗ — [≈] — ⊕ — φ

$LO_1$

302

φ

704

$LO_2 / LO_1$

706

702

703 — $LO_2$ — ⊕ φ

705

⊗ — Zero-IF$_2$, clean

**Fig. 7**

Fig. 8a

Fig. 8b

Fig. 9a

Fig. 9b

Fig. 10a

Fig. 10b

Fig. 11

Fig. 12a

Fig. 12b

Europäisches
Patentamt
European
Patent Office
Office européen
des brevets

# EUROPEAN SEARCH REPORT

Application Number

EP 09 25 2809

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 6 466 630 B1 (JENSEN JAMES ROBERT [US]) 15 October 2002 (2002-10-15) | 1-4,6-11 | INV. H03M1/08 H04L27/34 |
| Y | * column 1, lines 13-16; figures 2-3, 8, 10, 11 * * column 4, line 44 - column 12, line 48 * | 5 | |
| X | US 5 671 253 A (STEWART JOHN SIDNEY [US]) 23 September 1997 (1997-09-23) | 1-3,6-11 | |
| Y | * column 1, line 622 - column 2, line 17; figures 1, 5 * * column 3, line 50 - column 5, line 60 * | 4,5 | |
| Y | US 5 905 767 A (FUJIMURA AKINORI [JP]) 18 May 1999 (1999-05-18) * column 27, lines 65-67; figure 3 * | 4 | |
| Y | US 2008/079485 A1 (TAIPALE DANA [US] ET AL) 3 April 2008 (2008-04-03) * page 1, paragraph 1; figures 1-4 * * page 1, paragraph 5-8 * | 5 | |
| A,D | VAN VELDHOVEN R ET AL: "The effect of clock jitter on the DR of [Sigma][Delta] modulators" 2006 IEEE INTERNATIONAL SYMPOSIUM ON CIRCUITS AND SYSTEMS 21-24 MAY 2006 ISLAND OF KOS, GREECE, IEEE - PISCATAWAY, NJ, USA LNKD- DOI:10.1109/ISCAS.2006.1693147, 21 May 2006 (2006-05-21), pages 2009-2012, XP010938786 ISBN: 978-0-7803-9389-9 * the whole document * | 1-11 | TECHNICAL FIELDS SEARCHED (IPC) H03M H04L |

The present search report has been drawn up for all claims

| Place of search | Date of completion of the search | Examiner |
|---|---|---|
| Munich | 23 April 2010 | Brosa, Anna-Maria |

## ANNEX TO THE EUROPEAN SEARCH REPORT
## ON EUROPEAN PATENT APPLICATION NO.

EP 09 25 2809

This annex lists the patent family members relating to the patent documents cited in the above-mentioned European search report.
The members are as contained in the European Patent Office EDP file on
The European Patent Office is in no way liable for these particulars which are merely given for the purpose of information.

23-04-2010

| Patent document cited in search report | | Publication date | Patent family member(s) | | Publication date |
|---|---|---|---|---|---|
| US 6466630 | B1 | 15-10-2002 | NONE | | |
| US 5671253 | A | 23-09-1997 | AU | 701379 B2 | 28-01-1999 |
| | | | AU | 6403496 A | 10-02-1997 |
| | | | BR | 9609629 A | 06-04-1999 |
| | | | CN | 1191050 A | 19-08-1998 |
| | | | DE | 69633830 D1 | 16-12-2004 |
| | | | DE | 69633830 T2 | 23-02-2006 |
| | | | EP | 0872096 A1 | 21-10-1998 |
| | | | ES | 2227599 T3 | 01-04-2005 |
| | | | HK | 1015579 A1 | 11-09-2003 |
| | | | IN | 190362 A1 | 19-07-2003 |
| | | | JP | 11509063 T | 03-08-1999 |
| | | | JP | 3795528 B2 | 12-07-2006 |
| | | | PL | 324380 A1 | 25-05-1998 |
| | | | WO | 9703509 A1 | 30-01-1997 |
| US 5905767 | A | 18-05-1999 | CN | 1156369 A | 06-08-1997 |
| | | | GB | 2307154 A | 14-05-1997 |
| | | | HK | 1001169 A1 | 17-03-2000 |
| | | | JP | 3286885 B2 | 27-05-2002 |
| | | | JP | 9135276 A | 20-05-1997 |
| | | | SG | 74570 A1 | 22-08-2000 |
| US 2008079485 | A1 | 03-04-2008 | WO | 2008042134 A2 | 10-04-2008 |

EPO FORM P0459

For more details about this annex : see Official Journal of the European Patent Office, No. 12/82

EP 2 339 755 A1

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **R. VAN VELDHOVEN ; PETER NUIJTEN ; PAUL VAN ZEIJL.** The effect of clock jitter on the DR of $\Sigma\Delta$ modulators. *Proceedings ISCAS 2006,* May 2006, 2009-2012